# EUROPEAN PATENT SPECIFICATION

(11) **EP 3 539 163 B1**
(45) Date of publication and mention of the grant of the patent: **02.08.2023**
(21) Application number: 17832895.1
(22) Date of filing: 13.11.2017
(51) Int. Cl.: H10N 10/13, H10N 10/17, H02M 3/156

(54) **THERMAL ENERGY TO ELECTRICAL ENERGY EXTRACTION SYSTEM**
SYSTEM ZUR EXTRAKTION VON WÄRMEENERGIE IN ELEKTRISCHE ENERGIE
SYSTÈME D'EXTRACTION D'ÉNERGIE THERMIQUE EN ÉNERGIE ÉLECTRIQUE

(30) Priority: 14.11.2016 ZA 201607826
(43) Date of publication of application: 18.09.2019
(73) Proprietor: University Of South Africa, 0003 Pretoria (ZA)
(72) Inventor: SNYMAN, Lukas, Willem, 0003 Pretoria (ZA)
(74) Representative: Appleyard Lees IP LLP
(86) International application number: PCT/ZA2017/050084
(87) International publication number: WO 2018/090065

(56) References cited:
- WO-A1-2016/174002
- GB-A- 2 172 394
- GB-A- 2 493 092
- US-A1- 2004 129 308
- US-A1- 2004 176 859
- US-A1- 2009 301 539
- US-A1- 2016 293 824

## Description

### Technical field

This invention relates to harnessing thermal energy and to the conversion of thermal energy into electricity.

### Background

The inventor believes that energy savings can be achieved by improving thermal energy harvesting and associated energy storage systems.

Thermal energy is available in abundance, with some sunny areas exposed to approximately 1 kilowatt hour per square meter.

In addition to solar energy there are also many other unharvested sources of thermal energy, such as cars, power plants, factories and other industries, which all dissipate large amounts of thermal energy into the environment.

Photo voltaic solar electricity generators are not capable of capturing all of the energy contained in sunlight, with some sources stating that only about 20 percent is absorbed, and this 20 percent is only converted into electricity at an efficiency of around 10-15 percent.

The Seebeck effect entails that when there is a difference in temperature between two dissimilar electrical conductor or semiconductor substances, there will be a resulting electric potential difference (or Voltage difference) between the two substances. When the Seebeck effect is applied in reverse - in other words, when heat or cold is produced by applying an electrical current through two dissimilar electrical conductor or semiconductor substances - it is referred to as the Peltier effect.

GB 2 493 092 A discloses an electricity generation apparatus having thermal storage and thermoelectric heat exchanger which is designed to operate in day and night conditions. WO 2016/174002 A1 discloses a thermoelectric power generating system which has a microprocessor-based controller which is connected to voltage and current detectors to receive measured voltages and currents and to automatically control operation of DC-DC converters.

The inventor having considered the above proposes the invention hereinbelow.

### Summary of invention

According to a first aspect of the invention, there is provided a thermal energy to electrical energy extraction system according to claim 1 which includes:
a thermoelectric converter, for converting thermal energy into electrical energy and generating an electrical energy output, the thermoelectric converter being arranged interconnectably between a thermal energy storage tank and a solar collector;
an electric conditioner connectable to the thermoelectric converter for conditioning the electrical energy output and generating a conditioned electrical output;
a measuring means for measuring the electric energy within the system; and
a controller for controlling the thermoelectric converter in order to vary the conditioned ectrical output based on the measurements obtained from the measuring
means; and a closed loop pumping and circulation system comprising a thermal exchanger system which is configured to allow flow of thermal conducting fluid from the solar collector towards the thermal storage tank during solar energy supply, thereby transferring thermal energy collected by the solar collector to the thermal energy storage tank, and which is configured to allow flow of thermal conducting fluid from the thermal storage tank towards the solar collector during solar absence, thereby transferring thermal energy from the thermal energy storage tank towards the solar collector, thereby causing a temperature gradient across the thermoelectric converter in the presence as well as in the absence of solar energy supply for creating a continuous electricity supply.

The thermoelectric converter may be configured to convert thermal energy into electrical energy with a coinciding generated voltage and current.

The thermoelectric convertor may take the form of a Seebeck generator.

The thermoelectric convertor may take the form of a Peltier cell.

The thermoelectric convertor may take the form of a thermopile which includes:
a mounting base with apertures extending therethrough;
a first conductor mounted on a first surface of the mounting base;
a second conductor mounted on a second surface of the mounting base; and
protrusions extending from at least one of the conductors through the apertures for interconnecting the first and second conductors.

The mounting base may take the form of a printed circuit board.

The first and second conductors may be composed from different conductive materials.

The thermopile may further include semiconductor connectors located within the apertures for interconnecting the first and second conductors.

It is to be appreciated that when thermal energy flows from one conductor to the other a net voltage and current flow will be created. According to the invention, the thermal energy source indudes a thermal collector, the thermal collector being configured to convert solar energy into thermal energy.

The thermal energy source may include a fuel powered engine generating thermal energy as a by - product, a power plant for generating electricity, a factory, incinerator, a hot water reservoir functioning as a thermal storage tank, or any other object or source containing thermal energy.

The thermal energy source may be a black coloured body for absorbing solar energy. The electric conditioner may take the form of a direct current to direct current converter (DC to DC converter) for conditioning a voltage of an electrical source to a desired output voltage.

The electric conditioner may be configured to condition the generated voltage and current of the thermoelectric converter to required levels.

By controlling the electric conditioner, the desired output voltage and current can thus be regulated.

Designing the DC to DC converter may include selection of respective inductor and capacitors by taking into account the load or an applicable energy storage device. The DC to DC convertor may take the form of a conventional Boost convertor for stepping up voltage while stepping down current from its input to its output / supply. The thermal energy to electrical energy extraction system may include multiple electric conditioners.

The multiple electric conditioners may be connected in parallel to the electric supply generated by the thermoelectric converter in order to further condition the electric output so as to generate an optimised sine wave triangular load current.

The multiple electric conditioners may be connected in parallel to the thermal to electricity convertor, with each conditioner operating at a different phase time relative to a reference signal / phase character, so as to prevent overlapping of the off or dead time of the multiple conditioners with a resultant generally continuous flow of electricity from the convertor to the load.

The measuring means may take the form of voltage and / or current sensors.

The controller may take the form of a programmable micro controller.

The controller may be configured to provide an output control signal to a switching device included within the thermoelectric converter for manipulating the required conditioned output.

### Brief description of the drawings

The invention will now be described by means of a non-limiting example with reference to the accompanying drawings.

### In the drawings:

Figures 1 and 2 depict the electric conditioner in the form of a DC to DC convertor illustrating the concept of covering the voltage and current levels of a specific input source and the coinciding time cycles related thereto;
Figure 3 shows a schematic representation of the complete DC to DC electronic extractor system for optimizing the electricity extraction from the thermal to electricity conversion cell, utilising microprocessor control in order to optimise time sequencing;
Figure 4 is a graph illustrating the extraction current versus time for the inductor charge cycle of the DC to DC energy convertor, being the first cycle of the DC to DC energy extraction as depicted in Figure 3;
Figure 5 is a graph illustrating the transfer of charge current to the capacitor or battery, being the second cycle of the DC to DC extractor as depicted in Figure 3;
Figure 6 is a graph illustrating the effective final DC charge / current extracted from the system shown in Figures 1 and 2;
Figure 7 is a schematic representation of a large scale low cost thermal energy to electricity converter, with multiple DC to DC convertors sequentially separated from each other for ensuring an overlap of extraction cycles;
Figure 8 is a graph of the thermal energy versus time heat transfer and electricity output curves as obtained for the system shown in Figure 7, illustrating an almost continuous extraction of current over time;
Figure 9 is a graph of the observed power versus temperature difference performance for the complete thermal energy extraction unit;
Figures 10 and 11 show possible microelectronic structures for generating a microelectronic thermo-pile using different metal depositions on both sides of a printed circuit, in accordance with the second aspect of the invention; and
Figure 12 is a schematic illustration of a preferred embodiment larger scale low cost thermal energy to electricity converter that can be used for generating electricity for households using a multi cycle thermal transfer process, in the presence as well as in the absence of solar energy supply.

### Detailed description of the invention

Reference numeral 10 generally depicts a thermal energy extractor system 10, in accordance with the invention;

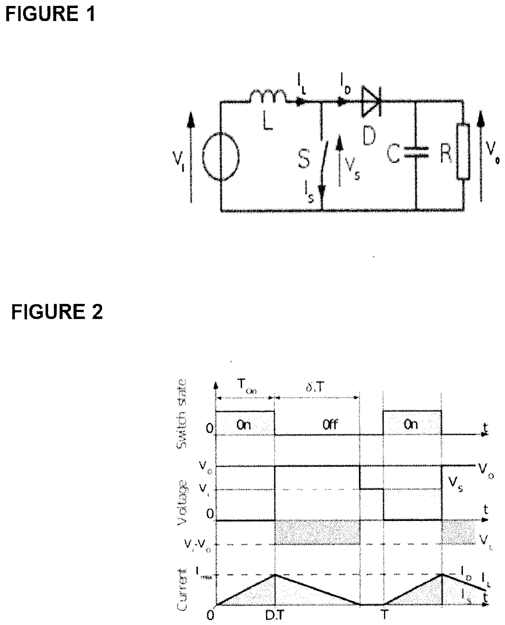

Turning now to Figures 1 and 2, the electric conditioner, in the form of a conventional DC to DC converter is typically controlled by varying the on - and - off timing (duty cycle) of a switching device included within the converter circuit. Designing a DC to DC converter it is important to select the respective inductor and capacitors taking into account the load or an applicable energy storage device.

The DC to DC convertor used will typically be a conventional Boost convertor for stepping up voltage while stepping down current from its input to its output / supply. The basic functioning of a Boost converter is firstly, in the on state the switch S is closed, resulting in a gradual rise in the current through the inductor. In the off state, with switch S in the open position, the current through the inductor flows through the diode D, the capacitor C and the Load R. The result is that energy accumulated within the inductor during the on state, is transferred into the capacitor. This energy can then be used to power the load R during the off stage.

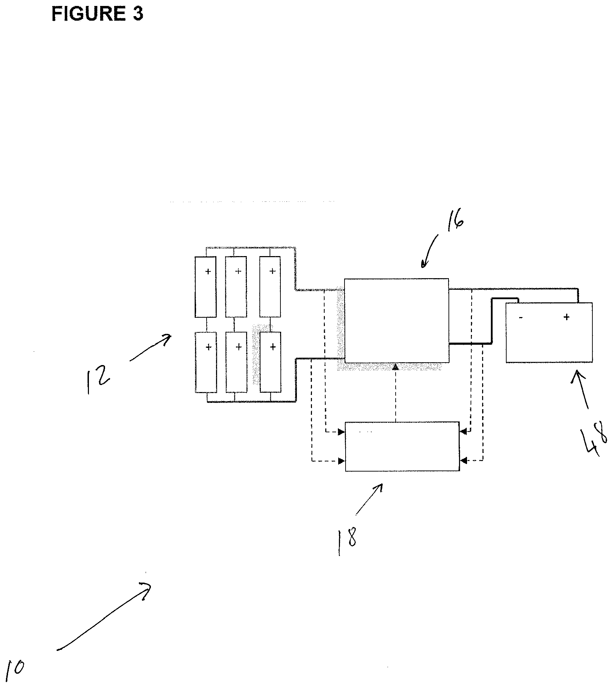

Figure 3 shows a schematic representation of a DC to DC convertor 16 electronic extractor system 10 for optimizing the electricity extraction from the thermoelectric convertor 12, utilising controller / microprocessor 18 in order to optimise time sequencing. Energy storage battery 48 is included to store electrical energy not supplied to the load.

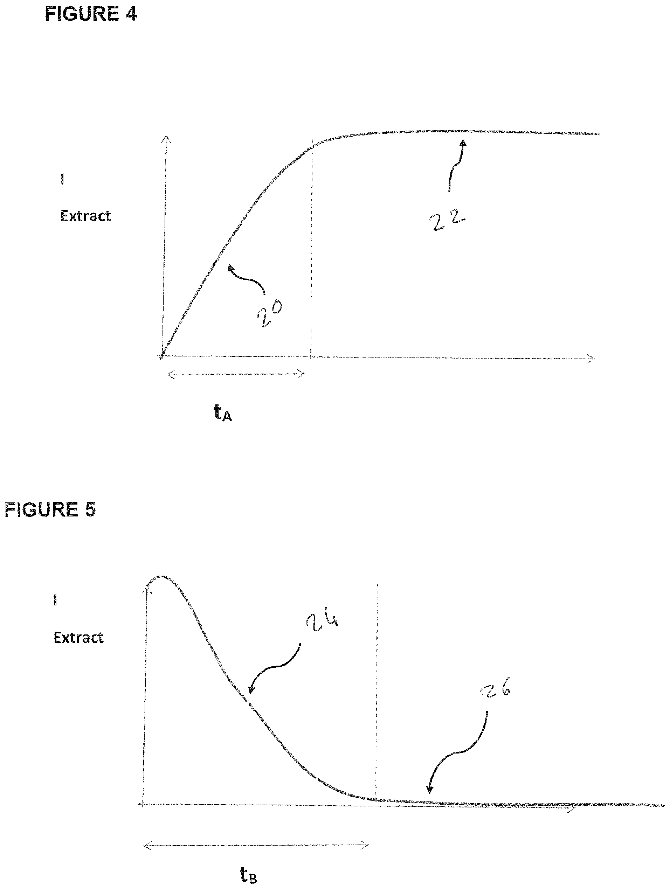

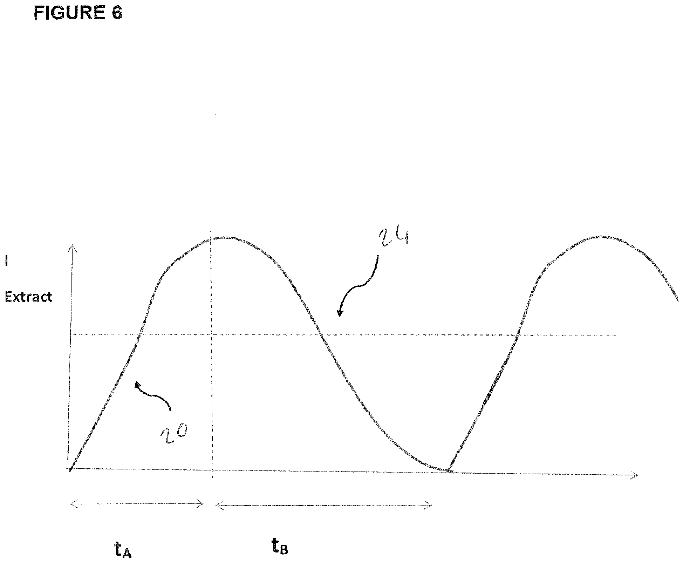

One limiting factor of a DC to DC converter is that the current through the inductor decays to zero, see Figures 4, 5 and 6. In such an event there may be serious implications to the efficacy of the DC to DC converter and to the energy harvesting capabilities of the entire system.

Figure 4 illustrates the extraction current versus time for the inductor charge cycle of the DC to DC convertor being the first cycle of the DC to DC extractor as depicted in

Figure 3, reference numeral 20 showing an initial increase in energy stored in the coil, followed by a time-period of no energy storage 22, in which period potential energy is no longer stored and wasted.

Figure 5 illustrates the transfer of charge current to the capacitor or battery, being the second cycle of the DC to DC extractor as depicted in Figure 3, reference numeral 24 showing a decrease in energy stored in the capacitor/battery over time, followed by a resultant period of no energy storage, 26.

Factors considered when designing the converter 12 are the applicable load, the size and inductance of the inductor as well as the size and capacitance of the capacitor. All the factors will also have an impact on the duty cycle of the switch and impact on the method in which the duty cycle is controlled by means of the controller 18.

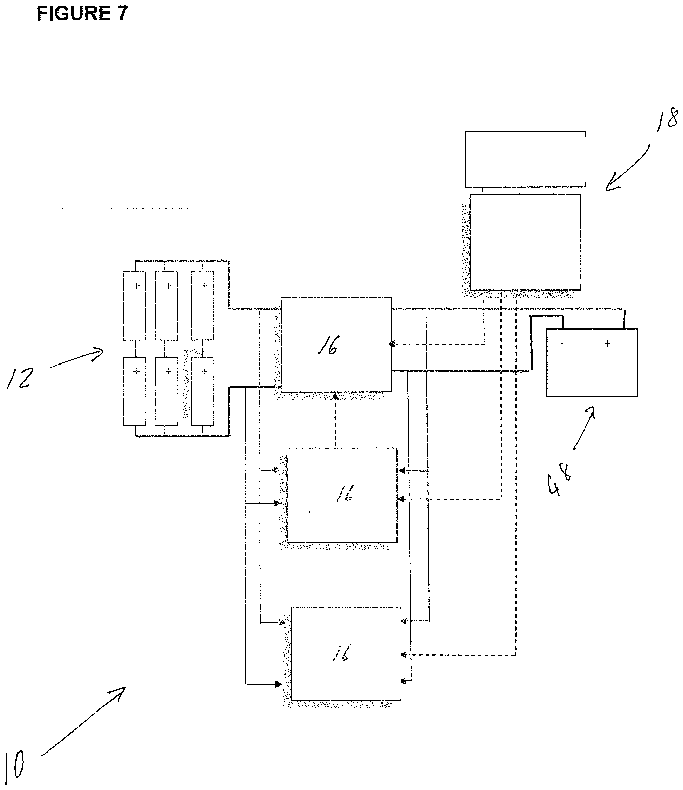

Thus, according to a first aspect of the invention, more clearly shown in Figure 7, there is provided a thermal energy to electrical energy extraction system 10 which includes a thermoelectric converter 12, connectable to a thermal energy source, an electric conditioner in the form of a DC to DC convertor 16, connectable to the thermoelectric converter 12 for conditioning the electric energy output of the thermoelectric converter 12, generating a conditioned electrical output and optimizing the conversion efficiency of thermal energy to electrical energy, a measuring means typically in the form of voltage and current sensors (not shown) for measuring the electric energy within the system 10 and a controller 18 for controlling the converter 12 in order to vary the conditioned electrical output based on the measurements obtained from the voltage and current sensors. Battery 48 is provided for storage of surplus electrical energy. The thermoelectric converter 12 will typically be in the form of a Seebeck generator. Alternatively, the thermoelectric convertor 12 can also be the form of a Peltier cell.

In use, the thermoelectric converter 12 is connected a thermal energy source which can be a hot water reservoir or a solar energy absorber/collector for converting thermal energy into electrical energy with a coinciding generated voltage and current. Electric conditioner 16 will preferably be in the form of a direct current to direct current converter (DC to DC converter) and will condition the generated voltage and current of the thermoelectric converter 12 to required levels.

By controlling the thermoelectric converter 12 the desired output voltage and current can thus be regulated.

In order to condition the electric output to, for instance, to generate an optimised sine wave triangular load current, Figure 7 further illustrates a plurality of electric conditioners 16 which are connected in parallel to the thermal to electricity convertor 12, with each conditioner 16 operating at a different phase time, relative to a reference signal and such that the off or dead time of each conditioner 16 does not coincide or occurs at the same time.

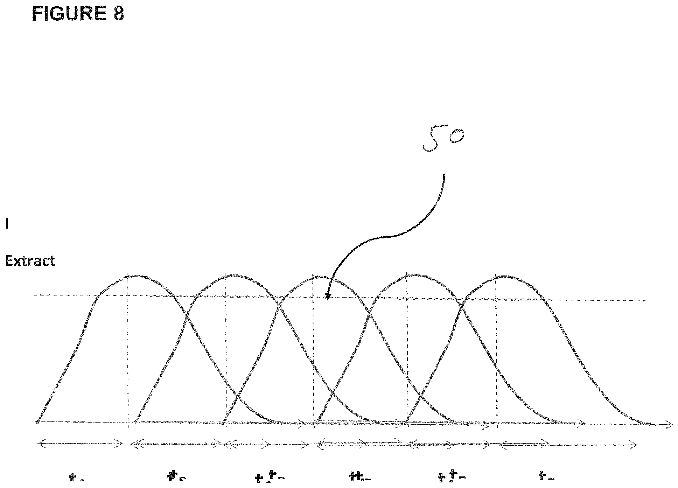

By optimizing the conditioner transfer times in terms of the reference signal (phase character), an almost continuous flow of electricity from the convertor to the load can be realized, see Figure 8 where reference numeral 50 indicates an optimized optimised sine wave triangular load current.

This configuration, technique and system, increases and optimizes the flow of electricity from the thermal to electricity converter to the load and increases the conversion efficiency of the system.

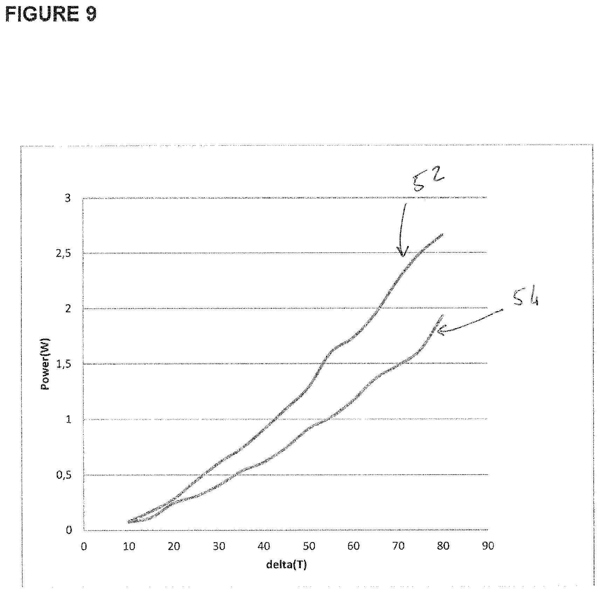

Figure 9 is a graphic representation showing the increase in electrical energy extraction when using a DC - DC convertor, reference numeral 52, compared to a reduced efficiency, reference numeral 54, when incorporating a direct load.

The controller 18 will be a programmable micro controller and the electronic conditioners 16 are typically controlled by analyzing the various electrical inputs and outputs measured by means of the voltage and current sensors.

The controller will typically provide an output control signal to a switching device included within the converter circuit in order to manipulate the required conditioned output.

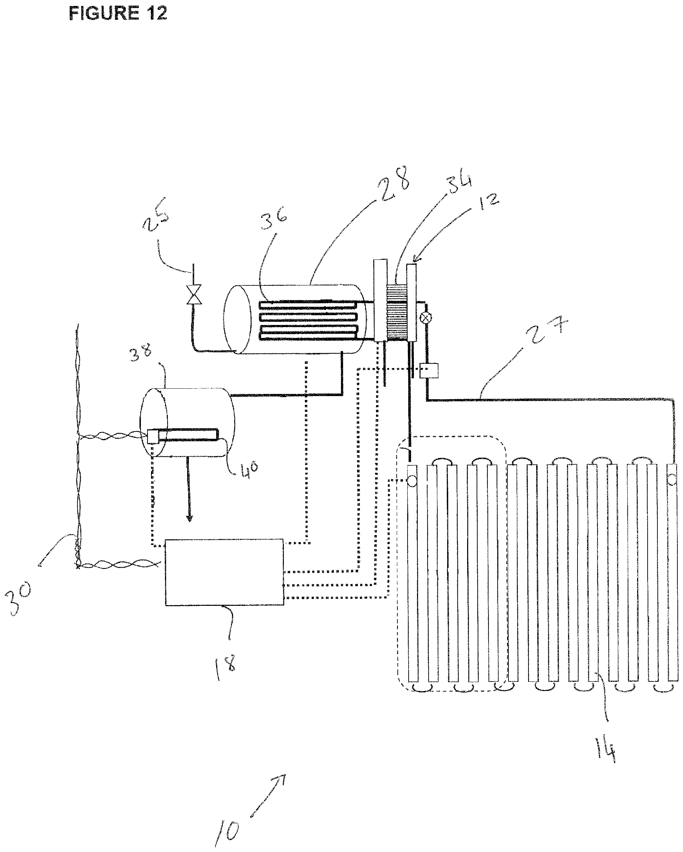

Figure 12 depicts a preferred embodiment, when in use, of the thermal energy extractor system 10, in accordance with the invention.

The system 10 includes a low cost black body thermal energy collector, or thermal energy source 14, consisting of an arrangement of black metal plates and pipes for converting solar energy into thermal energy. A suitable thermal conductive fluid, in this case water, is pumped and circulated within a thermal conductor which includes a closed loop pumping and circulation system 27 to a thermal energy transfer area where thermal energy is transferred to a thermal energy storage tank 28.

Thermal energy is harvested by the thermoelectric generator/convertor 12 which is a number of thermopiles 34 arranged in series, converting the thermal energy into electrical energy as the thermal energy conducting fluid passes therethrough.

The thermal energy is also transferred inside the thermal storage tank 28 by means of a thermal exchanger system 36, which in for this embodiment consists of a copper coil circulating the thermal energy conducting fluid. The closed loop pumping and circulation system 27 is closed cycle and the pressure in the thermal exchanger system 36 is thus not influenced by external water pressure as supplied from the supply line 25.

A secondary thermal storage tank 38, with a conventional electrical element heater 40 can be coupled to the first tank 28, in order to supply high temperature water to a household, should it be required.

A smart electronic controller 18 is coupled to a series of sensors and controls for ensuring that electricity is supplied by the thermal energy harvesting system at maximum efficiency.

During day time, thermal energy is collected by the thermal collector 14 and thermal energy is transferred through the pumping and closed loop liquid system 27 towards the thermal storage tank 28, the fluid passing through the thermoelectric generator 12.

It is estimated that about 30% of the transferred thermal energy through the thermoelectric generator 12 is converted to electric energy, and the electrical energy is fed to an external load/grid electricity supply 30 that is coupled to the system 10.

The remaining thermal energy that flows through the thermoelectric convertor 12 is subsequently stored in thermal storage tank 28. This is referred to as the first cycle of conversion.

An ordinary hot water geyser system found in many household is used for this purpose. Hot water can be drawn for various household purposes as occurs with a normal geyser system and fresh water can be supplied to the geyser from an external water line.

During night time, no solar energy is incident on the thermal collector 14 and if thermal conducting fluid (hot water) is circulated from the thermal storage tank 30 through the system 27, towards thermal collector 14, the surface of thermal collector 14 subsequently acts as a radiator transferring thermal energy to the cool night air environment. The temperature of the thermal collector 14 will hence be lower during night.

A temperature gradient is thus again available between thermal storage tank 28 and the thermal collector 14. When fluid is subsequently circulated towards the thermal collector 14 passing through the thermoelectric generator 12, again about 30 % of the thermal energy is converted into into electricity. This is referred to the second cycle of conversion.

A continuous supply of electricity is therefore supplied from the system 10 both during day and night.

Energy is effectively stored during day time as hot water in the reservoir 28. No expensive battery systems are required for storing energy. The total conversion efficiency of the system has been found to be as high as 60%. The cost outlay of the system is extremely low.

The closed loop pumping and circulation system will typically include electronic control units consisting of a range of sensors, electronic micro-processor, electronic driving circuitry and actuators (valves) control the flow of fluids continuously and ensures that the thermal energy to electricity conversion process always occurs optimally. The thermal energy extraction system 10 can alternatively include an energy storage device in the form of one or more batteries for storing excess electricity.

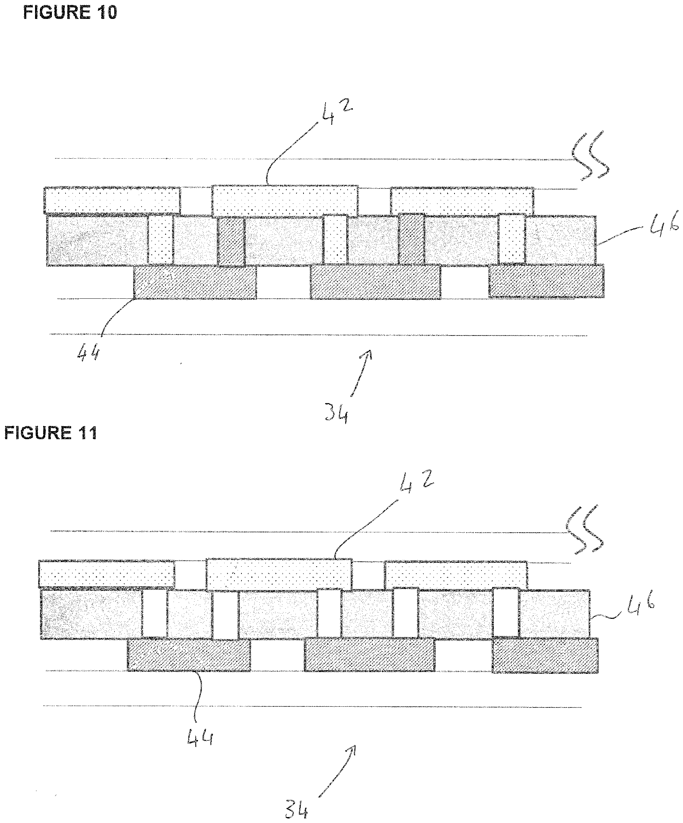

Figures 10 and 11 show possible microelectronic structures for generating the microelectronic thermo-pile 34 using different metal depositions 42 and 44, respectively, on both sides of a printed circuit 46.

Metal conductors 42 and 44 are made of different conductive materials.

It is to be appreciated that when thermal energy flows from one conductor to the other a net voltage and current flow will be created.

A major goal of these structures is to ensure that a maximum thermal gradient is maintained between the two sides of the structure, while a high thermal conduction occurs between the two sides, and a high electric conduction of charge carriers occurs between the two sides. Hence some elongation of the middle thermal conduction blocks is required.

The thermoelectric system is described which includes sequential extraction techniques to promote efficient conversion of thermal into electrical energy and also a substantial constant level of electrical energy output.

## Claims

1. A thermal energy to electrical energy extraction system (10) which includes:
a thermoelectric converter (12), for converting thermal energy into electrical energy and generating an electrical energy output, the thermoelectric converter being arranged interconnectably between a thermal energy storage tank (28) and a solar collector (14);
an electric conditioner (16) connectable to the thermoelectric converter (12) for conditioning the electrical energy output and generating a conditioned electrical energy output;
a measuring means for measuring the electrical energy within the system (10);
a controller (18) for controlling the thermoelectric converter (12) in order to thereby vary the conditioned electrical energy output based on the measurements obtained from the measuring means; and
a closed loop pumping and circulation system (27) comprising a thermal exchanger system (36) which is configured to allow flow of thermal conducting fluid from the solar collector (14) towards the thermal energy storage tank (28) during solar energy supply, thereby transferring thermal energy collected by the solar collector (14) to the thermal energy storage tank (28), and which is configured to allow flow of thermal conducting fluid from the thermal energy storage tank (28) towards the solar collector (14) during solar absence, thereby transferring thermal energy from the thermal energy storage tank (28) towards the solar collector (14), thereby causing a temperature gradient across the thermoelectric converter (12) in the presence as well as in the absence of solar energy supply for creating a continuous electricity supply.

2. A thermal energy to electrical energy extraction system (10) as claimed in claim 1 wherein the thermal energy storage tank (28) is coupled to a secondary thermal energy storage tank (38) having an electrical element heater (40).

3. A thermal energy to electrical energy extraction system (10) as claimed in any one or more of the preceding claims wherein the electric conditioner (16) is in the form of a direct current to direct current converter (DC to DC converter) for conditioning a voltage of an electrical source to a desired output voltage.

4. A thermal energy to electrical energy extraction system (10) as claimed in claim 3 wherein the DC to DC converter is in the form of a Boost converter for stepping up voltage while stepping down current from its input to its output.

5. A thermal energy to electrical energy extraction system (10) as claimed in any one or more of the preceding claims wherein the electric conditioner (16) is in the form of multiple electric conditioners, the multiple electric conditioners being connected in parallel to the electric supply generated by the thermoelectric converter (12) in order to further condition the electric output so as to generate an optimised sine wave triangular load current.

6. A thermal energy to electrical energy extraction system (10) as claimed in any one or more of the preceding claims wherein the electric conditioner (16) is in the form of multiple electric conditioners, the multiple electric conditioners being connected in parallel to the thermal to electricity converter, with each conditioner operating at a different phase time relative to a reference signal / phase character, so as to prevent overlapping of the off or deadtime of each of the multiple conditioners with a resultant generally continuous flow of electricity from the thermoelectric converter (12) to a load.

7. A thermal energy to electrical energy extraction system (10) as claimed in any one or more of the preceding claims wherein the thermoelectric converter (12) is in the form of a thermopile (34), the thermopile including:
a mounting base with apertures extending therethrough;
a first conductor (42) mounted on a first surface of the mounting base;
a second conductor (44) mounted on a second surface of the mounting base; and
protrusions extending from at least one of the conductors through the apertures for interconnecting the first and second conductors.

8. A thermal energy to electrical energy extraction system (10) as claimed in claim 7 wherein the mounting base is in the form of a printed circuit board (46).

9. A thermal energy to electrical energy extraction system (10) as claimed in any one or more of the preceding claims wherein the measuring means is selected from any one or more of the group consisting of voltage sensors and current sensors.

10. A thermal energy to electrical energy extraction system as claimed in any one or more of the preceding claims wherein the controller (18) is in the form of a programmable micro controller.

11. A thermal energy to electrical energy extraction system (10) as claimed in any one or more of the preceding claims wherein the controller (18) is configured to provide an output control signal to a switching device included within the thermoelectric converter (12) for manipulating the required conditioned output.

## Patentansprüche

1. Extraktionssystem zur Umwandlung von Wärmeenergie in elektrische Energie (10), das Folgendes aufweist:
einen thermoelektrischen Wandler (12) zur Umwandlung von thermischer Energie in elektrische Energie und zur Erzeugung eines elektrischen Energie-Outputs, wobei der thermoelektrische Wandler so ausgelegt ist, dass er mit einem Wärmeenergiespeichertank (28) und einem Solarkollektor (14) verbindbar ist;
eine elektrische Konditioniereinrichtung (16), die mit dem thermoelektrischen Wandler (12) verbunden werden kann, um den elektrischen Energie-Output zu konditionieren und einen konditionierten elektrischen Energie-Output zu erzeugen;
eine Messeinrichtung zum Messen der elektrischen Energie innerhalb des Systems (10);
eine Steuereinrichtung (18) zur Steuerung des thermoelektrischen Wandlers (12), um dadurch den konditionierten elektrischen Energie-Output, basierend auf den von der Messeinrichtung erhaltenen Messungen, zu variieren; und
ein Pumpen- und Zirkulationssystem (27) mit einem geschlossenen Kreislauf, das ein Wärmetauschsystem (36) aufweist, das so ausgelegt ist, dass während der Solarenergieversorgung ein Strom von wärmeleitendem Fluid vom Solarkollektor (14) in Richtung des Wärmeenergiespeichertanks (28) ermöglicht wird, so dass dadurch vom Solarkollektor (14) gesammelte Wärmeenergie in den Wärmeenergiespeichertank (28) überführt wird,
und das so ausgelegt ist, dass bei Abwesenheit von Solarenergie ein Strom von wärmeleitendem Fluid vom Wärmeenergiespeichertank (28) in Richtung des Solarkollektors (14) ermöglicht wird, wodurch ein Temperaturgradient über den thermoelektrischen Wandler (12) hinweg, sowohl in Gegenwart als auch bei Abwesenheit von Solarenergieversorgung, bewirkt wird, um kontinuierliche Elektrizitätsversorgung bereitzustellen.

2. Extraktionssystem zur Umwandlung von Wärmeenergie in elektrische Energie (10) gemäß Anspruch 1, wobei der Wärmeenergiespeichertank (28) an einen sekundären Wärmeenergiespeichertank (38) mit einem ein elektrisches Element aufweisendes Heizgerät (40) gekoppelt ist.

3. Extraktionssystem zur Umwandlung von Wärmeenergie in elektrische Energie (10) gemäß einem der vorhergehenden Ansprüche, wobei die elektrische Konditioniereinrichtung (16) in Form eines Gleichstrom-zu-Gleichstromwandlers (DC/DC-Wandler) zum Konditionieren einer Spannung einer elektrischen Quelle auf eine gewünschte Ausgangsspannung vorliegt.

4. Extraktionssystem zur Umwandlung von Wärmeenergie in elektrische Energie (10) gemäß Anspruch 3, wobei der DC/DC-Wandler in Form eines Boost-Wandlers zum Hochfahren von Spannung vorliegt, während Strom von seinem Eingang zu seinem Ausgang heruntergefahren wird.

5. Extraktionssystem zur Umwandlung von Wärmeenergie in elektrische Energie (10) gemäß einem der vorhergehenden Ansprüche, wobei die elektrische Konditioniereinrichtung (16) in Form von mehreren elektrischen Konditioniereinrichtungen vorliegt, wobei letztere parallel zur vom thermoelektrischen Wandler (12) erzeugten Stromversorgung geschaltet sind, um den elektrischen Output weiter zu konditionieren, so dass ein optimierter Sinuswellen-Dreiecklaststrom erzeugt wird.

6. Extraktionssystem zur Umwandlung von Wärmeenergie in elektrische Energie (10) gemäß einem der vorhergehenden Ansprüche, wobei die elektrische Konditioniereinrichtung (16) in Form von mehreren elektrischen Konditioniereinrichtungen vorliegt, wobei letztere parallel zum Wärme-zuStrom Wandler geschaltet sind, wobei jede Konditioniereinrichtung mit einer anderen Phasenzeit in Bezug auf ein Referenzsignal/Phasenzeichen arbeitet, um ein Überlappen der Aus- oder Totzeit jeder der mehreren Konditioniereinrichtungen zu verhindern, was einen, im Allgemeinen, kontinuierlichen Stromfluss vom thermoelektrischen Wandler (12) zu einer Last zur Folge hat.

7. Extraktionssystem zur Umwandlung von Wärmeenergie in elektrische Energie (10) gemäß einem der vorhergehenden Ansprüche, wobei der thermoelektrische Wandler (12) als Thermosäule (34) ausgebildet ist, wobei diese Folgendes aufweist:
einen Montagesockel mit Öffnungen, die sich durch diesen hindurch erstrecken;
einen ersten Leiter (42), der auf einer ersten Oberfläche des Montagesockels angebracht ist;
einen zweiten Leiter (44), der auf einer zweiten Oberfläche des Montagesockels angebracht ist; und
Vorsprünge, die sich von wenigstens einem der Leiter durch die Öffnungen erstrecken, um den ersten und den zweiten Leiter miteinander zu verbinden.

8. Extraktionssystem zur Umwandlung von Wärmeenergie in elektrische Energie (10) gemäß Anspruch 7, wobei der Montagesockel als Leiterplatte (46) ausgebildet ist.

9. Extraktionssystem zur Umwandlung von Wärmeenergie in elektrische Energie (10) gemäß einem der vorhergehenden Ansprüche, wobei die Messeinrichtung aus beliebigen Spannungs- und Stromsensoren ausgewählt ist.

10. Extraktionssystem zur Umwandlung von Wärmeenergie in elektrische Energie (10) gemäß einem der vorhergehenden Ansprüche, wobei die Steuereinrichtung (18) als programmierbare Mikrosteuereinrichtung ausgebildet ist.

11. Extraktionssystem zur Umwandlung von Wärmeenergie in elektrische Energie (10) gemäß einem der vorhergehenden Ansprüche, wobei die Steuereinrichtung (18) dazu ausgelegt ist, ein Ausgangssteuersignal an eine im thermoelektrischen Wandler (12) enthaltene Schaltvorrichtung bereitzustellen, um den erforderlichen konditionierten Output zu manipulieren.

## Revendications

1. Système d'extraction d'énergie thermique en énergie électrique (10) qui comprend :
un convertisseur thermoélectrique (12) pour convertir de l'énergie thermique en énergie électrique et générer une puissance d'énergie électrique, le convertisseur thermoélectrique étant disposé de manière à pouvoir être interconnecté entre un réservoir de stockage d'énergie thermique (28) et un collecteur solaire (14) ;
un conditionneur électrique (16) pouvant être connecté au convertisseur thermoélectrique (12) pour conditionner la puissance d'énergie électrique et générer une puissance d'énergie électrique conditionnée ;
un moyen de mesure pour mesurer l'énergie électrique à l'intérieur du système (10) ;
un dispositif de commande (18) pour commander le convertisseur thermoélectrique (12) afin de faire varier ainsi la puissance d'énergie électrique conditionnée sur la base des mesures obtenues à partir du moyen de mesure ; et
un système de pompage et de circulation en boucle fermée (27) comprenant un système à échangeur thermique (36) étant configuré de façon à permettre l'écoulement de fluide thermoconducteur depuis le collecteur solaire (14) vers le réservoir de stockage d'énergie thermique (28) au cours d'une alimentation en énergie solaire, transférant ainsi de l'énergie thermique collectée par le collecteur solaire (14) vers le réservoir de stockage d'énergie thermique (28),
et lequel est configuré pour permettre l'écoulement de fluide thermoconducteur depuis le réservoir de stockage d'énergie thermique (28) vers le collecteur solaire (14) pendant une absence d'énergie solaire, transférant ainsi de l'énergie thermique depuis le réservoir de stockage d'énergie thermique (28) vers le collecteur solaire (14), provoquant ainsi un gradient de température à travers le convertisseur thermoélectrique (12) en présence ainsi qu'en absence d'alimentation en énergie solaire pour produire une alimentation continue en électricité.

2. Système d'extraction d'énergie thermique en énergie électrique (10) selon la revendication 1, dans lequel le réservoir de stockage d'énergie thermique (28) est couplé à un réservoir de stockage d'énergie thermique (38) secondaire comprenant un dispositif de chauffage (40) comportant un élément électrique.

3. Système d'extraction d'énergie thermique en énergie électrique (10) selon l'une quelconque des revendications précédentes, dans lequel le conditionneur électrique (16) se présente sous la forme d'un convertisseur de courant continu en courant continu (convertisseur continu-continu) pour conditionner une tension d'une source électrique en tension de sortie souhaitée.

4. Système d'extraction d'énergie thermique en énergie électrique (10) selon la revendication 3, dans lequel le convertisseur continu-continu se présente sous la forme d'un convertisseur élévateur (convertisseur Boost) pour élever la tension tout en abaissant le courant de son entrée vers sa sortie.

5. Système d'extraction d'énergie thermique en énergie électrique (10) selon l'une quelconque des revendications précédentes, dans lequel le conditionneur électrique (16) se présente sous la forme de multiples conditionneurs électriques, ces derniers étant connectés en parallèle à l'alimentation électrique générée par le convertisseur thermoélectrique (12) afin de conditionner davantage la puissance électrique de façon à générer un courant de charge triangulaire à onde sinusoïdale optimisé.

6. Système d'extraction d'énergie thermique en énergie électrique (10) selon l'une quelconque des revendications précédentes, dans lequel le conditionneur électrique (16) se présente sous la forme de multiples conditionneurs électriques, ces derniers étant connectés en parallèle au convertisseur d'énergie thermique en électricité, chaque conditionneur fonctionnant à un temps de phase différent par rapport à un caractère de signal/phase de référence, de façon à empêcher le chevauchement de l'arrêt ou du temps mort de chacun des multiples conditionneurs entraînant ainsi un flux d'électricité généralement continu depuis le convertisseur thermoélectrique (12) vers une charge.

7. Système d'extraction d'énergie thermique en énergie électrique (10) selon l'une quelconque des revendications précédentes, dans lequel le convertisseur thermoélectrique (12) se présente sous la forme d'une thermopile (34), ce dernier comprenant :
une base de montage avec des ouvertures s'étendant à travers celle-ci ;
un premier conducteur (42) monté sur une première surface de la base de montage ;
un second conducteur (44) monté sur une seconde surface de la base de montage ; et
des saillies s'étendant à partir d'au moins l'un des conducteurs à travers les ouvertures pour interconnecter les premier et second conducteurs.

8. Système d'extraction d'énergie thermique en énergie électrique (10) selon la revendication 7, dans lequel la base de montage se présente sous la forme d'une carte de circuit imprimé (46).

9. Système d'extraction d'énergie thermique en énergie électrique (10) selon l'une quelconque des revendications précédentes, dans lequel le moyen de mesure est sélectionné parmi des capteurs de tension et de courant quelconques.

10. Système d'extraction d'énergie thermique en énergie électrique (10) selon l'une quelconque des revendications précédentes, dans lequel le dispositif de commande (18) se présente sous la forme d'un microcontrôleur programmable.

11. Système d'extraction d'énergie thermique en énergie électrique (10) selon l'une quelconque des revendications précédentes, dans lequel le dispositif de commande (18) est configuré pour fournir un signal de commande de sortie à un dispositif de commutation, inclus dans le convertisseur thermoélectrique (12), pour manipuler la puissance conditionnée requise.
